# EUROPÄISCHE PATENTSCHRIFT

(11) **EP 2 031 662 B1**
(45) Veröffentlichungstag und Bekanntmachung des Hinweises auf die Patenterteilung: **02.07.2014**
(21) Anmeldenummer: 08162727.5
(22) Anmeldetag: 21.08.2008
(51) Int. Cl.: H01L 31/048, B32B 17/10, C09D 123/08, C08F 218/08

(54) **EVM in Solarmodulen**
EVM in solar modules
EVM dans des modules solaires

(30) Priorität: 29.08.2007 DE 102007041055
(43) Veröffentlichungstag der Anmeldung: 04.03.2009
(73) Patentinhaber: LANXESS Deutschland GmbH, 50569 Köln (DE)
(72) Erfinder: Bergmann, Gerd, 50676, Köln (DE); Deimel, Gerd, 51375, Leverkusen (DE); Hermann, Michael, 50829, Köln (DE); Kremers, Arndt, 52146, Würselen (DE); Mezger, Martin, 51399, Burscheid (DE); Zumaque, Harry, 50968, Köln (DE)

(56) Entgegenhaltungen:
- EP-A1- 1 164 167
- EP-A1- 1 184 912
- EP-A2- 0 341 499
- DE-A1- 3 825 450

## Beschreibung

Die vorliegende Erfindung betrifft ein Solarmodul, enthaltend mindestens eine Schicht aufgebaut aus mindestens einem α-Olefin-Vinylacetat-Copolymer mit einem Vinylacetat-Gehalt von ≥ 40 Gew.-%, bezogen auf das Gesamtgewicht des α-Olefin-Vinylacetat-Copolymeren, das nach einem Lösungspolymerisations-Verfahren bei einem Druck von 100 bis 700 bar hergestellt ist, die Verwendung des genannten α-Olefin-Vinylacetat-Copolymeren in Solarmodulen, die Verwendung des erfindungsgemäßen Solarmoduls zur stationären oder mobilen Stromerzeugung sowie eine Solarstromanlage, die mindestens ein erfindungsgemäßes Solarmodul enthält.

Mit Hilfe von Solarmodulen, die das Licht der Sonne direkt in elektrische Energie umwandeln, werden natürliche Ressourcen zur Stromerzeugung nutzbar.

Der wichtigste Bestandteil von Solarmodulen sind Solarzellen, wodurch die direkte Umwandlung des Sonnenlichts in elektrische Energie erfolgt. Die Solarmodule werden häufig in Außenbereichen, z.B. an Gebäuden, eingesetzt. Die in den Solarmodulen vorhandenen Solarzellen müssen daher vor Umwelteinflüssen geschützt werden. Da eindringende Feuchtigkeit die Lebensdauer der Solarzellen und somit des Solarmoduls durch Korrosion stark verkürzen kann, kommt der dauerhaften Verkapselung (Einbettung) der Solarzellen eine besondere Bedeutung zu. Das zur Verkapselung der Solarzellen verwendete Material muss für das Sonnenlicht transparent sein und gleichzeitig die kostengünstige Herstellung der Solarmodule ermöglichen. Ein im Stand der Technik häufig eingesetztes Material zur Einbettung der Solarzellen sind Ethylen-Vinylacetat-Copolymere.

Beispielsweise betrifft WO-A-97/22637 ein im Wesentlichen transparentes und farbloses Einbettungsmaterial, das frei von Absorberkomponenten für ultraviolettes Licht ist und aus einer Polymerkomponente und einem Vernetzungsreagenz aufgebaut ist. Als Polymerkomponente wird gemäß WO-A-97/22637 bevorzugt Ethylen-Vinylacetat eingesetzt. Gemäß Beispiel 1 in WO-A-97/22637 wird ein statistisches Ethylen-Vinylacetat-Copolymer, aufgebaut aus 67 Gew.-% Ethylen und 33 Gew.-% Vinylacetat, eingesetzt.

In EP 1 164 167 A1 sind Verkapselungsmaterialien, umfassend ein Ethylen-Vinylacetat-Copolymer (EVA), einen Vernetzer und einen Polymerisationsinhibitor, offenbart. Gemäß EP 1 164 167 A1 weist das EVA einen Vinylacetat-Gehalt von 5 bis 50 Gew.-% auf. Bei Gehalten oberhalb von 50 Gew.-% verschlechtern sich gemäß EP 1 164 167 A1 die mechanischen Eigenschaften des EVA und es wird schwierig, EVA-Filme herzustellen. Bezüglich des Herstellungsverfahrens des in EP 1 164 167 A1 eingesetzten EVA enthält EP 1 164 167 A1 keine Angaben. Gemäß den Beispielen 1 und 2 in EP 1 164 167 A1 wird ein EVA-Copolymer mit 26 Gew.-% Vinylacetat eingesetzt.

EP 1 184 912 A1 betrifft ebenfalls ein Einbettungsmaterial für Solarzellen, das aus einem Ethylen-Vinylacetat-Copolymer (EVA) aufgebaut ist. Gemäß EP 1 184 912 A1 beträgt der Vinylacetet-Gehalt in dem EVA-Copolymer 10 bis 40 Gew.-%. Gehalte von mehr als 40 Gew.-% Vinylacetat sind gemäß EP 1 184 912 A1 ungünstig, da EVA-Copolymere mit Gehalten von mehr als 40 Gew.-% Vinylacetat leicht fließen und so den Einbettungsprozess der Solarzellen erschweren. Des Weiteren zeichnen sich EVA-Copolymere mit einem Vinylacetat-Gehalt von mehr als 40 Gew.-% gemäß EP 1 184 912 A1 dadurch aus, dass sie klebrig sind, so dass die für die Einbettung verwendete EVA-Folie schwierig zu handhaben ist. Die bevorzugt eingesetzten EVA-Filme werden gemäß EP 1 184 912 A1 vernetzt.

In JP-A 2003-051605 ist eine Folie für ein Solarmodul offenbart, aufgebaut aus einem EVA-Copolymer, das mit einem organischen Peroxid, einem Silan-Kopplungsreagenz und Stabilisatoren vermischt ist. Der Vinylacetat-Gehalt in dem EVA-Copolymer gemäß JP-A 2003-051605 beträgt 27 % oder mehr. In den Beispielen wird ein EVA-Copolymer mit einem Vinylacetat-Gehalt von 28 % eingesetzt.

JP-A 2003-049004 betrifft einen flexiblen Film, der ohne Vernetzung zur Einbettung von Solarzellen geeignet ist. Der flexible Film ist bevorzugt aus einem Ethylen-Polymer oder einem Ethylen-α-Olefin-Copolymer oder einem Ethylen-Acrylat-Copolymer aufgebaut. Gemäß der Beschreibung in JP-A 2003-049004 sollen zu EVA-Systemen alternative Systeme bereitgestellt werden.

Aufgabe der vorliegenden Erfindung gegenüber dem Stand der Technik ist es, Solarmodule bzw. Einbettungsmaterialien für Solarzellen bereitzustellen, die sich durch eine gute Lebensdauer, hervorragende UV-Beständigkeiten und eine vereinfachte Fixierung der Solarzellen auszeichnen.

Diese Aufgabe wird durch ein Solarmodul gelöst, enthaltend mindestens eine Schicht aufgebaut aus mindestens einem α-Olefin-Vinylacetat-Copolymer.

Das erfindungsgemäße Solarmodul ist dann dadurch gekennzeichnet, dass das α -Olefin-Vinylacetat-Copolymer einen Vinylacetat-Gehalt von ≥ 40 Gew.-%, bezogen auf das Gesamtgewicht des α-Olefin-Vinylacetat-Copolymeren, aufweist und nach einem Lösungspolymerisations-Verfahren bei einem Druck von 100 bis 700 bar hergestellt ist.

Überraschenderweise wurde gefunden, dass die erfindungsgemäß verwendeten α -Olefin-Vinylacetat-Copolymere, die nach einem Lösungspolymerisations-Verfahren bei einem Druck von 100 bis 700 bar hergestellt sind, trotz des im Stand der Technik, z.B. in EP 1 164 167 A1 und EP 1 184 912 A1, als nachteilig beschriebenen hohen Vinylacetatgehalts hervorragend für den Einsatz in Solarmodulen geeignet sind.

Die erfindungsgemäß eingesetzten α-Olefin-Vinylacetat-Copolymeren zeichnet sich durch hervorragende UV-Beständigkeiten auf, und mit Hilfe der erfindungsgemäß eingesetzten α -Olefin-Vinylacetat-Copolymere ist eine gegenüber den im Stand der Technik eingesetzten Ethylen-Vinylacetat-Copolymeren vereinfachte Fixierung der Solarzellen möglich, wodurch im Laminationsprozess bei der Herstellung der erfindungsgemäßen Solarmodule Zeit und Energie eingespart werden können.

Die erfindungsgemäß eingesetzten α-Olefin-Vinylacetat-Copolymere zeichnen sich durch hohe Vinylacetat-Gehalte von ≥ 40 Gew.-%, bezogen auf das Gesamtgewicht des α -Olefin-Vinylacetat-Copolymeren, bevorzugt durch Vinylacetatgehalte von ≥ 50 Gew.-%, besonders bevorzugt ≥ 60 Gew.-%, jeweils bezogen auf das Gesamtgewicht der α-Olefin-Vinylacetat-Copolymere, aus. Üblicherweise beträgt der Vinylacetat-Gehalt der erfindungsgemäß eingesetzten α -Olefin-Vinylacetat-Copolymere ≥ 40 Gew.-% bis 98 Gew.-%, bevorzugt ≥ 50 Gew.-% bis 98 Gew.-%, besonders bevorzugt ≥ 60 Gew.-% bis 98 Gew.-% und der α-Olefin-Gehalt 2 Gew.-% bis ≤ 60 Gew.-%, bevorzugt 2 Gew.-% bis ≤ 50 Gew.-%, besonders bevorzugt 2 Gew.-% bis ≤ 40 Gew.-%,
wobei die Gesamtmenge an Vinylacetat und α-Olefin 100 Gew,-% beträgt.

In einer weiteren Ausführungsform kann das erfindungsgemäß eingesetzte α -Olefin-Vinylacetat-Copolymer neben den auf dem α-Olefin und Vinylacetat basierenden Monomereinheiten ein oder mehrere weitere Comonomereinheiten aufweisen (z.B. Terpolymere), z.B. basierend auf Vinylestern und/oder (Meth)acrylaten. Die weiteren Comonomereinheiten sind - wenn überhaupt weitere Comonomereinheiten in dem α-Olefin-Vinylacetat-Copolymer vorliegen, in einem Anteil von bis zu 10 Gew.-%, bezogen auf das Gesamtgewicht des α-Olefin-Vinylacetat-Copolymeren vorhanden, wobei sich der Anteil der auf dem α-Olefin basierenden Monomereinheiten auf entsprechend verringert. Somit können z.B. α-Olefin-Vinylacetat-Copolymere eingesetzt werden, die aus ≥ 40 Gew.-% bis 98 Gew.-% Vinylacetat, 2 Gew.-% bis ≤ 60 Gew.-% α-Olefin und 0 bis 10 Gew.-% mindestens eines weiteren Comonomeren aufgebaut sind, wobei die Gesamtmenge an Vinylacetat, α-Olefin und dem weiteren Comonomeren 100 Gew.-% beträgt.

Als α-Olefine können in den erfindungsgemäß eingesetzten α-Olefin-Vinylacetat-Copolymeren alle bekannten α-Olefine eingesetzt werden. Bevorzugt ist das α-Olefin ausgewählt aus Ethen, Propen, Buten, insbesondere n-Buten und i-Buten, Penten, Hexen, insbesondere 1-Hexen, Hepten und Octen, insbesondere 1-Octen. Es können auch höhere Homologe der genannten α-Olefine als α -Olefine in den erfindungsgemäß eingesetzten α-Olefin-Vinylacetat-Copolymeren eingesetzt werden. Die α-Olefine können des Weiteren Substituenten tragen, insbesondere C₁-C₅-Alkylreste. Bevorzugt tragen die α-Olefine jedoch keine weiteren Substituenten. Des Weiteren ist es möglich, in den erfindungsgemäß eingesetzten α-Olefin-Vinylacetat-Copolymeren Mischungen zweier oder mehrerer verschiedener α-Olefine einzusetzen. Bevorzugt ist es jedoch, keine Mischungen verschiedener α-Olefine einzusetzen. Bevorzugte α-Olefine sind Ethen und Propen, wobei Ethen besonders bevorzugt als α-Olefin in den erfindungsgemäß eingesetzten α -Olefin-Vinylacetet-Copolymeren eingesetzt wird. Somit handelt es sich bei dem bevorzugt in dem erfindungsgemäßen Solarmodul eingesetzten α-Olefin-Vinylacetat-Copolymer um ein Ethylen-Vinylacetat-Copolymer.

Besonders bevorzugte Ethylen-Vinylacetat-Copolymere weisen einen Vinylacetat-Gehalt von ≥ 40 Gew.-% bis 98 Gew.-%, bevorzugt ≥ 50 Gew.-% bis 98 Gew.-%, besonders bevorzugt ≥ 60 Gew.-% bis 98 Gew.-% und einen Ethylen-Gehalt von 2 Gew.-% bis ≤ 60 Gew.-%, bevorzugt 2 Gew.-% bis ≤ 50 Gew.-%, besonders bevorzugt 2 Gew.-% bis ≤ 40 Gew.-%, wobei die Gesamtmenge an Vinylacetat und Ethylen 100 Gew.-% beträgt.

Das erfindungsgemäß eingesetzte α-Olefin-Vinylacetat-Copolymer, bevorzugt Ethylen-Vinylacetat-Copolymer, wird nach einem Lösungspolymerisations-Verfahren bei einem Druck von 100 bis 700 bar, bevorzugt bei einem Druck von 100 bis 400 bar, hergestellt. Das Lösungspolymerisations-Verfahren wird bevorzugt bei Temperaturen von 50 bis 150 °C durchgeführt, wobei im Allgemeinen radikalische Initiatoren verwendet werden.

Üblicherweise werden die erfindungsgemäß bevorzugt eingesetzten Ethyen-Vinylacetet-Copolymere mit hohen Vinylacetat-Gehalten als EVM-Copolymere bezeichnet, wobei das "M" in der Bezeichnung das gesättigte Rückgrat der Methylen-Hauptkette des EVMs andeutet.

Geeignete Herstellungsverfahren für die erfindungsgemäß eingesetzten α -Olefin-Vinylacetat-Copolymere sind zum Beispiel in EP-A 0 341 499, EP-A 0 510 478 und DE-A 38 25 450 genannt.

Die erfindungsgemäß eingesetzten α-Olefin-Vinylacetat-Copolymere mit hohen Vinylacetat-Gehalten, die nach dem Lösungspolymerisations-Verfahren bei einem Druck von 100 bis 700 bar hergestellt werden, zeichnen sich insbesondere durch niedrige Verzweigungsgrade und damit niedrige Viskositäten aus. Des Weiteren weisen die erfindungsgemäß eingesetzten α -Olefin-Vinylacetat-Copolymere eine statistisch gleichmäßige Verteilung ihrer Bausteine (α-Olefin und Vinylacetat) auf.

Die erfindungsgemäß verwendeten α-Olefin-Vinylacetat-Copolymere, bevorzugt Ethylen-Vinylacetat-Copolymere, weisen im Allgemeinen MFI-Werte (g/10 min), gemessen nach ISO 1133 bei 190 °C und einer Last von 21,1 N, von 1 bis 40, bevorzugt 1 bis 10, besonders bevorzugt 2 bis 6.

Die Mooney-Viskositäten gemäß DIN 53 523 ML 1+4 bei 100 °C betragen im Allgemeinen 3 bis 50, bevorzugt 4 bis 35 Mooney-Einheiten.

Das zahlenmittlere durchschnittliche Molekulargewicht, bestimmt mittels GPC, beträgt im Allgemeinen von 5000 g/mol bis 200000 g/mol, bevorzugt 10000 g/mol bis 100000 g/mol.

Besonders bevorzugt werden in dem erfindungsgemäßen Solarmodul Ethylen-Vinylacetat-Copolymere eingesetzt, die zum Beispiel unter den Handelnamen Levapren^{®} oder Levamelt^{®} der Lanxess AG kommerziell erhältlich sind.

Besonders bevorzugt eingesetzte a-Olefin-Copolymerisate sind die Ethylen-Vinylacetat-Copolymere Levamelt^{®} 600, Levamelt^{®} 700, Levamelt^{®} 800 und Levamelt^{®} 900 mit 60±1,5 Gew.-% Vinylacetat, 70±1,5 Gew.-% Vinylacetat, 80±2 Gew.-% Vinylacetat bzw. 90±2 Gew.-% Vinylacetat.

Bei Einsatz der erfindungsgemäß verwendeten α-Olefin-Vinylacetat-Copolymere werden Solarmodule erhalten, die eine längere Standzeit aufweisen als Solarmodule, die Ethylen-Vinylacetat-Copolymere mit geringeren Vinylacetat-Gehalten und - aufgrund des unterschiedlichen Herstellungsverfahrens - anderen Produkteigenschaften, aufweisen.

Die erfindungsgemäß verwendeten α-Olefin-Vinylacetat-Copolymere können vernetzt oder unvernetzt sein. Ein besonderer Vorteil der erfindungsgemäß eingesetzten α -Olefin-Vinylacetat-Copolymere ist, dass in einer bevorzugten Ausführungsform der vorliegenden Erfindung auf eine Vernetzung der α-Olefin-Vinylacetat-Copolymere bei Einsatz in dem erfindungsgemäßen Solarmodul verzichtet wird. In einer bevorzugten Ausführungsform betrifft die vorliegende Erfindung somit ein erfindungsgemäßes Solarmodul, worin die erfindungsgemäß eingesetzten α -Olefin-Vinylacetat-Copolymere in unvernetzter Form vorliegen.

Dies ist ein großer Vorteil gegenüber den üblicherweise in Solarmodulen eingesetzten EVA-Copolymeren mit geringeren Vinylacetat-Gehalten, die mit Hilfe von Peroxiden vernetzt werden müssen.

Insbesondere sind die folgenden Vorteile zu nennen, die sich bei Einsatz der erfindungsgemäß verwendeten, bevorzugt unvernetzten, α-Olefin-Vinylacetat-Copolymere - insbesondere bei der Herstellung der Solarmodule - ergeben:
- Energetisch: Da der Schritt der peroxidischen Vernetzung in einer bevorzugten Ausführungsform entfällt, kann prinzipiell bei geringeren Temperaturen laminiert werden, da keine Aktivierungstemperatur erreicht werden muss, um die Reaktion zu starten;
- Zykluszeit bei der Herstellung der Solarmodule:
   Diese fällt kürzer aus, da der o. g. Vernetzungsschritt entfällt. Dies bedeutet einen höheren Durchsatz.
- weniger Wartungsaufwand:
   Die Maschinen, in denen der Vernetzungsschritt vorgenommen wird, werden nicht den aggressiven Spaltprodukten ausgesetzt. Die Maschine und die beweglichen Komponenten darin leben länger und benötigen weniger Wartung. Dies bedeutet wieder eine Ersparnis in Material- aber auch Leerstandkosten.

Ein weiterer Vorteil der erfindungsgemäßen Verwendung der genannten α -Olefin-Vinylacetat-Copolymere ist, dass bei Einsatz der genannten α-Olefin-Vinylacetat-Copolymere in Solarmodulen weder Haftvermittler noch Alterungsschutzmittel benötigt werden, da die intrinsische Klebrigkeit des erfindungsgemäß verwendeten Materials für die Anwendung genügt, und weil der in Vergleich zu im Stand der Technik eingesetzten EVAs höhere VA-Anteil im EVM einen inhärenten Schutz gegen UV ergibt.

Ein weiterer Gegenstand der vorliegenden Erfindung ist daher ein erfindungsgemäßes Solarmodul, enthaltend mindestens eine Schicht, aufgebaut aus mindestens einem erfindungsgemäß verwendeten vorstehend genannten α-Olefin-Vinylacetat-Copolymer, wobei die Schicht keine Alterungsschutzmittel, insbesondere keine UV-Stabilisatoren, und/oder keine Haftvermittler, insbesondere keine Silanhaftvermittler, besonders bevorzugt weder Alterungsschutzmittel noch Haftvermittler, enthält.

Kern der Erfindung ist die Verwendung der vorstehend erwähnten α -Olefin-Vinylacetat-Copolymere in Solarmodulen. Bei dem erfindungsgemäßen Solarmodul kann es sich um ein beliebiges, dem Fachmann bekanntes Solarmodul handeln, soweit dieses mindestens eine Schicht aus mindestens einem erfindungsgemäß eingesetzten α-Olefin-Vinylacetat-Copolymeren enthält. Geeignete Solarmodule sind nachstehend erwähnt.

In einer bevorzugten Ausführungsform ist das erfindungsgemäße Solarmodul aus den folgenden Schichten aufgebaut:
i) einem Glas-Substrat A mit einer Vorder- und Rückseite, , wobei die Vorderseite die in dem fertigen Solarmodul zur Sonne gewandte Seite ist;
ii) einer auf die Rückseite des Glas-Substrats aufgebrachten transparenten Polymerschicht B;
iii) eine oder mehrere auf die Polymerschicht B aufgebrachte Solarzellen C;
iv) einer weiteren, auf die Solarzellen aufgebrachten transparenten Polymerschicht D;
v) einer Schutzschicht E;
wobei die Solarzellen C in die transparenten Polymerschichten B und D eingebettet sind,
wobei eine der transparenten Polymerschichten B und/oder D aus mindestens einem erfindungsgemäß eingesetzten α-Olefin-Vinylacetat-Copolymeren aufgebaut ist.

Geeignete und bevorzugt geeignete erfindungsgemäß eingesetzte α -Olefin-Vinylacetat-Copolymere sind vorstehend genannt.

Bevorzugt weist das erfindungsgemäße Solarmodul zusätzlich eine Anschlussdose und ein Anschlussterminal sowie - wenn es sich um ein starres Solarmodul handelt - einen Rahmen, bevorzugt einen Aluminiumprofil-Rahmen, auf.
Als Glas-Substrat A sind Glasscheiben geeignet, wobei bevorzugt ein so genanntes Einscheiben-Sicherheits-Glas (ESG) eingesetzt wird. Es sind alle dem Fachmann bekannten Glas-Substrate geeignet, wobei des Weiteren unter "Glas-Substrat" auch andere transparente Substrate, wie z.B. Polycarbonat, zu verstehen sind.

Geeignete transparente Polymerschichten B und D sind α-Olefin-Vinylacetat-Copolymere, insbesondere Ethylen-Vinylacetat-Copolymere, wobei mindestens eine Polymerschicht B oder D, bevorzugt beide Polymerschichten B und D, aus dem erfindungsgemäß eingesetzten α -Olefin-Vinylacetat-Copolymer, das vorstehend definiert wurde, aufgebaut sind.

Als Solarzellen C sind alle dem Fachmann bekannten Solarzellen geeignet. Geeignete Solarzellen sind Siliziumzellen, wobei es sich um Dickschichtzellen (mono- oder polykristalline Zellen) oder Dünnschichtzellen (amorphes Silizium oder kristallines Silizium) handeln kann; III-V-Halbleiter Solarzellen (Ga-As-Zellen); II-VI-Halbleiter Solarzellen (CdTe-Zellen); CIS-Zellen (Kupfer-Indium-Diselenid oder Kupfer-Indium-Disulfid) oder CIGS-Zellen (Kupfer-Indium-Gallium-Diselenid); organische Solarzellen, Farbstoffzellen (Grätzel-Zellen) oder Halbleiter-Elektrolytzellen (z. B. Kupferoxid/NaCl-Lösung); wobei Siliziumzellen bevorzugt eingesetzt werden. Dabei können alle dem Fachmann bekannten Typen von Siliziumzellen eingesetzt werden, z. B. monokristalline Zellen, polykristalline Zellen, amorphe Zellen, mikrokristalline Zellen oder Tandem-Solarzellen, die z. B. aus einer Kombination von polykristallinen und amorphen Zellen aufgebaut sind. Bevorzugt werden polykristalline und amorphe Zellen eingesetzt.

Neben Dickschichtzellen können Dünnschichtzellen, Konzentratorzellen, elektrochemische Farbstoff-Solarzellen, organische Solarzellen oder Fluoreszenz-Zellen eingesetzt werden. Des Weiteren können flexible Solarzellen eingesetzt werden. Die erfindungsgemäß verwendeten α -Olefin-Vinylacetat-Copolymere sind - im Gegensatz zu üblicherweise in Solarzellen eingesetzten EVA-Copolymeren - Elastomere und daher besonders gut für den Einsatz in flexiblen Solarzellen geeignet. Die Strukturen der vorstehend genannten Solarzellen sind dem Fachmann bekannt.

Geeignete Verfahren zur Herstellung der Solarzellen C sind dem Fachmann bekannt.

Üblicherweise enthält das erfindungsgemäße Solarmodul mehrere Solarzellen, die zum Beispiel durch so genannte Lötbändchen elektrisch miteinander verschaltet sind. Die Solarzellen C sind in die transparenten Polymerschichten B und D eingebettet.

Des Weiteren enthält das erfindungsgemäße Solarmodul eine Schutzschicht E, die auf die transparente Polymerschicht D aufgebracht ist. Bei der Schutzschicht E handelt es sich im Allgemeinen um eine witterungsfeste Schutzschicht, die die Rückseite (Rückseitenkaschierung) des Solarmoduls bildet. Dabei handelt es sich üblicherweise um eine Kunststofffolie, insbesondere eine Kunststoffverbundfolie, zum Beispiel aufgebaut aus Polyvinylfluorid, z.B. Tedlar^{®} von DuPont, oder Polyester.

Die bevorzugt zusätzlich in dem erfindungsgemäßen Solarmodul vorliegende Anschlussdose ist zum Beispiel eine Anschlussdose mit Freilaufdiode bzw. Bypass-Diode. Diese Freilauf- oder Bypass-Dioden sind zum Schutz des Solarmoduls erforderlich, wenn zum Beispiel durch Verschattung oder einen Defekt kein Strom durch das Solarmodul geliefert wird.

Weiterhin weist das Solarmodul bevorzugt ein Anschlussterminal auf, das den Anschluss des Solarmoduls an eine Solarstromanlage ermöglicht.

Schließlich weist das Solarmodul - wenn es sich um ein starres Solarmodul handelt - in einer bevorzugten Ausführungsform einen Rahmen, zum Beispiel einen Aluminiumprofil-Rahmen, zur Erhöhung der Stabilität des Solarmoduls auf.

Die einzelnen vorstehend genannten Elemente des Solarmoduls und bevorzugte Ausführungsformen dieser Elemente sind dem Fachmann bekannt.

Das erfindungsgemäße Solarmodul wird nach üblichen, dem Fachmann bekannten Verfahren hergestellt. Im Allgemeinen wird zunächst das entsprechende, im Allgemeinen gereinigte Glas-Substrat A bereitgestellt, worauf die transparente Polymerschicht B, die bevorzugt aus dem erfindungsgemäß verwendeten α-Olefin-Vinylacetat-Copolymeren aufgebaut ist, aufgebracht wird. Üblicherweise wird die transparente Polymerschicht B vor der Aufbringung auf das Glas-Substrat zugeschnitten. Anschließend werden die Solarzellen C auf der transparenten Polymerschicht B positioniert, wobei sie im Allgemeinen vorher mittels so genannter Lötbändchen zu einzelnen Strängen (strings) verbunden werden. Anschließend werden üblicherweise Querverbinder, die die einzelnen Stränge miteinander verbinden und zur Anschlussdose führen, positioniert und gegebenenfalls verlötet. Schließlich wird die weitere transparente Polymerschicht D, die bevorzugt aus dem erfindungsgemäß eingesetzten α-Olefin-Vinylacetat-Copolymer aufgebaut ist, und im Allgemeinen vor Aufbringung zugeschnitten wird, aufgebracht. Anschließend erfolgt die Aufbringung der Schutzschicht E.

Im Anschluss an die Aufbringung der einzelnen Schichten erfolgt ein Laminieren des erfindungsgemäßen Solarmoduls. Das Laminieren erfolgt nach dem Fachmann bekannten Verfahren, zum Beispiel bei Unterdruck und erhöhter Temperatur (zum Beispiel 100 bis 200 °C). Durch das Laminieren wird erreicht, dass die Solarzellen in die transparenten Polymerschichten B und D eingebettet werden und fest mit dem Glas-Substrat A und der Schutzschicht E verbunden sind. Anschließend wird im Allgemeinen die Anschlussdose gesetzt und das Modul gerahmt.

Die einzelnen Verfahrensschritte zur Herstellung des erfindungsgemäßen Solarmoduls erfolgen gemäß dem Fachmann bekannten Verfahren.

Die erfindungsgemäß eingesetzten α-Olefin-Vinylacetat-Copolymere können auch in Solarmodulen eingesetzt werden, die einen von dem vorstehend genannten bevorzugten Aufbau unterschiedlichen Aufbau aufweisen. Weitere Arten von Solarmodulen, worin die erfindungsgemäß eingesetzten α -Olefin-Vinylacetat-Copolymere eingesetzt werden können, sind dem Fachmann bekannt. Beispiele sind laminierte Glas-Glas-Module, Glas-Glas-Module in Gießharztechnik, Glas-Glas-Module in Verbundsicherheitsfolien-Technologie, Dünnschicht-Module hinter Glas oder als flexible Beschichtung, zum Beispiel auf Kupferband, Konzentrator-Module, worin das Sonnenlicht mit Hilfe einer Optik auf kleinere Solarzellen konzentriert wird, sowie Fluoreszenzkollektoren.

Die erfindungsgemäß eingesetzten α-Olefin-Vinylacetat-Copolymere weisen gegenüber üblicherweise in Solarmodulen eingesetzten Ethylen-Vinylacetat-Copolymeren (EVA) vorteilhafte Eigenschaften auf, z.B. weniger maschinenschädliche Emissionen beim Produktionsprozess, hervorragende Alterungsbeständigkeit, insbesondere UV-Beständigkeit, und vereinfachte Fixierung der Solarzellen, wodurch eine Zeit- und Energieersparnis im Laminationsprozess erreicht wird. Des Weiteren können durch den Einsatz der erfindungsgemäß eingesetzten α -Olefin-Vinylacetat-Copolymere längere Standzeiten erzielt werden als bei Einsatz üblicher EVA-Copolymere.

Ein weiterer Gegenstand der vorliegenden Erfindung ist die Verwendung des erfindungsgemäßen Solarmoduls zur stationären und mobilen Stromerzeugung.

Üblicherweise erfolgt die Stromerzeugung in einer Solarstromanlage, die mindestens ein erfindungsgemäßes Solarmodul aufweist, worin die Lichtenergie der Sonne in elektrische Energie umgewandelt wird, sowie mindestens einem elektrischen Verbraucher.

Ein weiterer Gegenstand der vorliegenden Erfindung ist somit eine Solarstromanlage enthaltend mindestens ein erfindungsgemäßes Solarmodul.

Geeignete elektrische Verbraucher sind von dem Typ der Solarstromanlage abhängig. Zum Beispiel kann es sich bei dem Verbraucher um einen Gleichstromverbraucher oder um einen Wechselstromverbraucher handeln. Wenn ein Wechselstromverbraucher angeschlossen ist, ist es erforderlich, den aus den Solarmodulen erhaltenen Gleichstrom mittels eines Wechselrichters in Wechselstrom umzuwandeln. Es ist ebenfalls möglich, dass Solarstromanlagen eingesetzt werden, die sowohl Gleichstromverbraucher als auch Wechselstromverbraucher enthalten.

Die Solarstromanlage kann des Weiteren ein Inselsystem sein, die keine (direkte) Verbindung zu einem Stromnetz aufweist. Üblicherweise wird der in einem Inselsystem gewonnene Strom in Akkumulatoren als Energiespeicher (Verbraucher im Sinne der vorliegenden Anmeldung) gepuffert. Geeignete Inselsysteme sind dem Fachmann bekannt.

Des Weiteren kann es sich bei den Solarstromanlagen um netzgekoppelte Anlagen handeln, wobei die Solarstromanlage an ein eigenständiges Stromnetz angeschlossen ist und die elektrische Energie in dieses Stromnetz eingespeist wird. In diesem Fall ist der Verbraucher somit das Stromnetz. Geeignete netzgekoppelte Anlagen sind dem Fachmann ebenfalls bekannt.

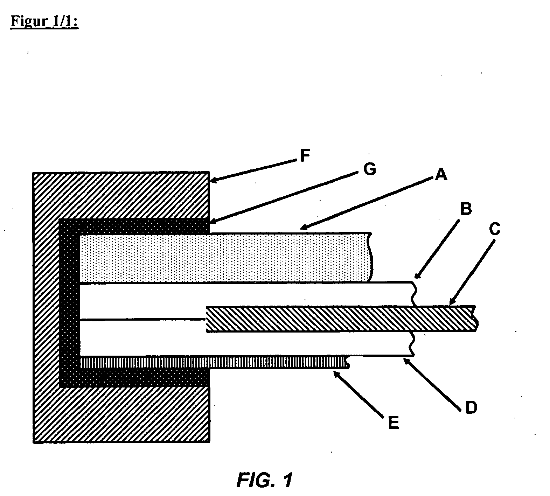

In Figur 1 ist ein Beispiel für ein erfindungsgemäßes, bevorzugtes Solarmodul dargestellt.

In Figur 1 bedeuten:
A Glas-Substrat
B transparente Polymerschicht, aufgebaut aus mindestens einem erfindungsgemäß eingesetzten α -Olefin-Vinylacetat-Copolymeren, bevorzugt einem erfindungsgemäß eingesetzten Ethylen-Vinylacetat-Copolymeren, besonders bevorzugt einem Ethylen-Vinylacetat-Copolymeren mit der Bezeichnung Levamelt^{®} von Lanxess AG;
C Solarzellen;
D transparente Polymerschicht, aufgebaut aus mindestens einem erfindungsgemäß eingesetzten α -Olefin-Vinylacetat-Copolymeren, bevorzugt einem erfindungsgemäß eingesetzten Ethylen-Vinylacetat-Copolymeren, bevorzugt einem Ethylen-Vinylacetet-Copolymeren mit der Bezeichnung Levamelt^{®} von Lanxess AG;
E eine Schutzschicht;
F Rahmen, bevorzugt ein Aluminiumprofil-Rahmen;
G Dichtung.

Figur 1 stellt eine bevorzugte Ausführungsform des erfindungsgemäßen Solarmoduls dar. Gegenstand der Erfindung sind auch Solarmodule, die keine Komponenten F und G aufweisen. Insbesondere kann die Komponente F bei flexiblen Solarmodulen entfallen.

Geeignete Komponenten A, B, C, D, E und F wurden bereits vorstehend näher beschrieben. Geeignete Dichtungen G sind dem Fachmann bekannt.

## Patentansprüche

1. Sólarmodul, enthaltend Einbettungsmaterialien für Solarzellen in mindestens eine Schicht, aufgebaut aus mindestens einem α-Olefin-Vinylacetat-Copolymeren, **dadurch gekennzeichnet, dass** das α-Olefin-VinylacetatCopolymere einen Vinylacetat-Gehalt von ≥ 40 Gew.-%, bezogen auf das Gesamtgewicht des α-Olefin-Vinylacetat-Copolymeren, aufweist und nach einem Lösungspolymerisations-Verfahren bei einem Druck von 100 bis 700 bar hergestellt ist.

2. Solarmodul nach Anspruch 1, **dadurch gekennzeichnet, dass** das α-Olefin-Vinylacetat-Copolymer einen Vinylacetat-Gehalt von ≥ 50 Gew.-%, bevorzugt ≥ 60 Gew.-%, besonders bevorzugt ≥ 80 Gew.-% jeweils bezogen auf das Gesamtgewicht des α-Olefin-Vinylacetat-Copolymeren, aufweist.

3. Solarmodul nach Anspruch 1 oder 2, **dadurch gekennzeichnet, dass** das α-Olefin in dem α-Olefin-Vinylacetat-Copolymeren ausgewählt ist aus Ethen, Propen, Buten, Penten, Hexen, Hepten und Octen, bevorzugt Ethen und Propen, besonders bevorzugt Ethen.

4. Solarmodul nach einem der Ansprüche 1 bis 3, **dadurch gekennzeichnet, dass** das α-Olefin-Vinylacetat-Copolymer einen MFI-Wert (g/10 min), gemessen nach ISO 1133 bei 190 °C und einer Last von 21,1 N, von 1 bis 40, bevorzugt 1 bis 10, besonders bevorzugt 2 bis 6, aufweist.

5. Solarmodul nach einem der Ansprüche 1 bis 4, **dadurch gekennzeichnet, dass** das α-Olefin-Vinylacetat-Copolymer eine Mooney-Viskosität gemäß DIN 53 523 ML 1+4 bei 100 °C von 3 bis 50, bevorzugt 4 bis 35 Mooney-Einheiten aufweist.

6. Solarmodul nach einem der Ansprüche 1 bis 5, **dadurch gekennzeichnet, dass** das zahlenmittlere durchschnittliche Molekulargewicht des α-Olefin-Vinylacetat-Copolymeren, bestimmt mittels GPC, 5000 g/mol bis 200000 g/mol beträgt.

7. Solarmodul nach einem der Ansprüche 1 bis 6, **dadurch gekennzeichnet, dass** das α-Olefin-Vinylacetat-Copolymer in unvernetzter Form vorliegt.

8. Solarmodul nach einem der Ansprüche 1 bis 7, **dadurch gekennzeichnet, dass** die mindestens eine Schicht, aufgebaut aus dem mindestens einen α-Olefin-Vinylacetat Copolymeren keine Alterungsschutzmittel und/oder keine Haftvermittler aufweist.

9. Solarmodul nach einem der Ansprüche 1 bis 8, aufgebaut aus
i) einem Glas-Substrat A mit einer Vorder- und Rückseite, wobei die Vorderseite die in dem fertigen Solarmodul zur Sonne gewandte Seite ist;
ii) einer auf die Rückseite des Glas-Substrats aufgebrachten transparenten Polymerschicht B;
iii) eine oder mehrere auf die Polymerschicht B aufgebrachte Solarzellen C;
iv) einer weiteren, auf die Solarzellen aufgebrachten transparenten Polymerschicht D;
v) einer Schutzschicht E;
wobei die Solarzellen C in die transparenten Polymerschichten B und D eingebettet sind, **dadurch gekennzeichnet, dass** mindestens eine der transparenten Polymerschichten B und/oder D, bevorzugt beide transparenten Polymerschichten B und D, aus einem α-Olefin-Vinylacetat-Copolymeren, wie in einem der Ansprüche 1 bis 7 definiert, aufgebaut sind.

10. Solarmodul nach Anspruch 9, **dadurch gekennzeichnet, dass** zusätzlich eine Anschlussdose und ein Anschlussterminal und ein Rahmen, bevorzugt ein Aluminiumprofil-Rahmen, vorliegen.

11. Verwendung eines α-Olefin-Vinylacetat-Copolymeren, wie in einem der Ansprüche 1 bis 7 definiert, in Solarmodulen.

12. Verwendung eines Solarmoduls gemäß einem der Ansprüche 1 bis 10 zur stationären und mobilen Stromerzeugung.

13. Solarstromanlage, enthaltend mindestens ein Solarmodul gemäß einem der Ansprüche 1 bis 10.

## Claims

1. Solar module containing embedding materials for solar cells in at least one layer made up of at least one α-olefin-vinyl acetate copolymer, **characterized in that** the α-olefin-vinyl acetate copolymer has a vinyl acetate content of ≥ 40% by weight, based on the total weight of the α-olefin-vinyl acetate copolymer, and has been prepared by a solution polymerization process at a pressure of from 100 to 700 bar.

2. Solar module according to Claim 1, **characterized in that** the α-olefin-vinyl acetate copolymer has a vinyl acetate content of ≥ 50% by weight, preferably ≥ 60% by weight, particularly preferably ≥ 80% by weight, in each case based on the total weight of the α-olefin-vinyl acetate copolymer.

3. Solar module according to Claim 1 or 2, **characterized in that** the α-olefin in the α-olefin-vinyl acetate copolymer is selected from among ethene, propene, butene, pentene, hexene, heptene and octene, preferably ethene and propene, particularly preferably ethene.

4. Solar module according to any of Claims 1 to 3, **characterized in that** the α-olefin-vinyl acetate copolymer has an MFI (g/10 min) measured in accordance with ISO 1133 at 190°C under a load of 21.1 N of from 1 to 40, preferably from 1 to 10, particularly preferably from 2 to 6.

5. Solar module according to any of Claims 1 to 4, **characterized in that** the α-olefin-vinyl acetate copolymer has a Mooney viscosity ML 1 + 4 at 100°C measured in accordance with DIN 53 523 of from 3 to 50 Mooney units, preferably from 4 to 35 Mooney units.

6. Solar module according to any of Claims 1 to 5, **characterized in that** the number average molecular weight of the α-olefin-vinyl acetate copolymer determined by means of GPC is from 5000 g/mol to 200 000 g/mol.

7. Solar module according to any of Claims 1 to 6, **characterized in that** the α-olefin-vinyl acetate copolymer is present in uncrosslinked form.

8. Solar module according to any of Claims 1 to 7, **characterized in that** the at least one layer made up of the at least one α-olefin-vinyl acetate copolymer contains no ageing inhibitors and/or no bonding agents.

9. Solar module according to any of Claims 1 to 8 which is made up of
i) a glass substrate A having a front side and a rear side, with the front side being the side facing the sun in the finished solar module;
ii) a transparent polymer layer B applied to the rear side of the glass substrate;
iii) one or more solar cells C applied to the polymer layer B;
iv) a further transparent polymer layer D applied on top of the solar cells;
v) a protective layer E;
where the solar cells C are embedded in the transparent polymer layers B and D,
**characterized in that** at least one of the transparent polymer layers B and/or D, preferably both transparent polymer layers B and D, is/are made up of an α-olefin-vinyl acetate copolymer as defined in any of Claims 1 to 7.

10. Solar module according to Claim 9, **characterized in that** a connection socket and a connection terminal and a frame, preferably an aluminium profile frame, are additionally present.

11. Use of an α-olefin-vinyl acetate copolymer as defined in any of Claims 1 to 7 in solar modules.

12. Use of a solar module according to any of Claims 1 to 10 for stationary and mobile power generation.

13. Solar power plant containing at least one solar module according to any of Claims 1 to 10.

## Revendications

1. Module solaire, contenant des matériaux d'encastrement pour cellules solaires dans au moins une couche, formé à partir d'au moins un copolymère α-oléfine-acétate de vinyle, **caractérisé en ce que** le copolymère α-oléfine-acétate de vinyle présente une teneur en acétate de vinyle ≥ 40 % en poids, par rapport au poids total du copolymère α-oléfine-acétate de vinyle, et est fabriqué par un procédé de polymérisation en solution à une pression de 100 à 700 bar.

2. Module solaire selon la revendication 1, **caractérisé en ce que** le copolymère α-oléfine-acétate de vinyle présente une teneur en acétate de vinyle ≥ 50 % en poids, de préférence ≥ 60 % en poids, de manière particulièrement préférée ≥ 80 % en poids, à chaque fois par rapport au poids total du copolymère α-oléfine-acétate de vinyle.

3. Module solaire selon la revendication 1 ou 2, **caractérisé en ce que** l'α-oléfine dans le copolymère α-oléfine-acétate de vinyle est choisie parmi l'éthène, le propène, le butène, le pentène, l'hexène, l'heptène et l'octène, de préférence l'éthène et le propène, de manière particulièrement préférée l'éthène.

4. Module solaire selon l'une quelconque des revendications 1 à 3, **caractérisé en ce que** le copolymère α-oléfine-acétate de vinyle présente une valeur MFI (g/10 min), mesurée selon ISO 1133 à 190 °C et à une charge de 21,1 N, de 1 à 40, de préférence de 1 à 10, de manière particulièrement préférée de 2 à 6.

5. Module solaire selon l'une quelconque des revendications 1 à 4, **caractérisé en ce que** le copolymère α-oléfine-acétate de vinyle présente une viscosité de Mooney selon DIN 53 523 ML 1+4 à 100 °C de 3 à 50, de préférence de 4 à 35 unités Mooney.

6. Module solaire selon l'une quelconque des revendications 1 à 5, **caractérisé en ce que** le poids moléculaire moyen en nombre du copolymère α-oléfine-acétate de vinyle, déterminé par CPG, est de 5 000 g/mol à 200 000 g/mol.

7. Module solaire selon l'une quelconque des revendications 1 à 6, **caractérisé en ce que** le copolymère α-oléfine-acétate de vinyle se présente sous forme non réticulée.

8. Module solaire selon l'une quelconque des revendications 1 à 7, **caractérisé en ce que** la ou les couches formées à partir du ou des copolymères α-oléfine-acétate de vinyle ne comprennent pas d'agent antivieillissement et/ou pas de promoteur d'adhésion.

9. Module solaire selon l'une quelconque des revendications 1 à 8, formé à partir de :
i) un substrat en verre A comprenant un côté avant et un côté arrière, le côté avant étant le côté tourné vers le soleil dans le module solaire fini ;
ii) une couche polymère transparente B appliquée sur le côté arrière du substrat en verre ;
iii) une ou plusieurs cellules solaires C appliquées sur la couche polymère B ;
iv) une couche polymère transparente D supplémentaire appliquée sur les cellules solaires ;
v) une couche de protection E ;
les cellules solaires C étant encastrées dans les couches polymères transparentes B et D,
**caractérisé en ce qu'**au moins une des couches polymères transparentes B et/ou D, de préférence les deux couches polymères transparentes B et D, sont formées à partir d'un copolymère α-oléfine-acétate de vinyle tel que défini dans l'une quelconque des revendications 1 à 7.

10. Module solaire selon la revendication 9, **caractérisé en ce qu'**un boîtier de raccordement et un terminal de raccordement et un cadre, de préférence un cadre profilé en aluminium, sont également présents.

11. Utilisation d'un copolymère α-oléfine-acétate de vinyle tel que défini dans l'une quelconque des revendications 1 à 7 dans des modules solaires.

12. Utilisation d'un module solaire selon l'une quelconque des revendications 1 à 10 pour la production d'électricité stationnaire et mobile.

13. Système photovoltaïque, contenant au moins un module solaire selon l'une quelconque des revendications 1 à 10.
